(19)

**Europäisches Patentamt**
**European Patent Office**
**Office européen des brevets**

(11) **EP 4 603 791 A1**

(12) **EUROPEAN PATENT APPLICATION**
published in accordance with Art. 153(4) EPC

(43) Date of publication:
**20.08.2025  Bulletin 2025/34**

(21) Application number: **23916116.9**

(22) Date of filing: **20.10.2023**

(51) International Patent Classification (IPC):
***G01B 11/06*** *(2006.01)*

(52) Cooperative Patent Classification (CPC):
**G01B 11/06**

(86) International application number:
**PCT/JP2023/038071**

(87) International publication number:
**WO 2024/150498 (18.07.2024 Gazette 2024/29)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **10.01.2023   JP 2023001844**

(71) Applicant: **Hamamatsu Photonics K.K.
Hamamatsu-shi, Shizuoka 435-8558 (JP)**

(72) Inventors:
• **OHTSUKA Kenichi
Hamamatsu-shi, Shizuoka 435-8558 (JP)**
• **MORISHIMA Kota
Hamamatsu-shi, Shizuoka 435-8558 (JP)**
• **TSUCHIYA Kunihiko
Hamamatsu-shi, Shizuoka 435-8558 (JP)**

(74) Representative: **Grünecker Patent- und
Rechtsanwälte
PartG mbB
Leopoldstraße 4
80802 München (DE)**

(54) **FILM THICKNESS MEASURING DEVICE AND FILM THICKNESS MEASURING METHOD**

(57)    A film thickness measuring apparatus is a film thickness measuring apparatus that measures a film thickness of a sample in which a film is formed on a substrate, and includes a light source configured to irradiate the sample with light in a planar manner, an area sensor configured to image light from the sample, a calculation unit configured to derive a measurement parameter related to the sample based on a signal from the area sensor, a storage unit configured to store relationship information between the film thickness and the measurement parameter, and an analysis unit configured to derive the film thickness of the sample based on the relationship information and the measurement parameter related to the sample obtained by the calculation unit. The relationship information is derived based on the theoretical reflectance according to the type of film and the spectral characteristics of the entire film thickness measuring apparatus.

*Fig.1*

EP 4 603 791 A1

**Description**

**Technical Field**

One aspect of the present disclosure relates to a film thickness measuring apparatus and a film thickness measuring method.

**Background Art**

Patent Literature 1 discloses a technique of using a dichroic mirror, whose transmittance and reflectance change according to a wavelength, to separate light from an object, obtaining a wavelength centroid by imaging each of the light separated, and estimating a film thickness of the object based on the wavelength centroid.

**Citation List**

**Patent Literature**

Patent Literature 1: WO 2021/161986 A

**Summary of Invention**

**Technical Problem**

In the film thickness measuring method using the wavelength centroid described above, it is necessary to perceive the relationship between the film thickness and the wavelength centroid in advance. Examples of a method for obtaining such a relationship include a method of using a reference sample. The method involves preparing a plurality of reference samples having different film thicknesses, calculating the wavelength centroid for each of them, plotting the wavelength centroid with respect to the film thickness, and using a fitting method to derive the relationship related to the plotted data.

Here, the relationship between the film thickness and the emphasis on wavelength derived by using the method described above varies depending on the type of film of the sample that is symmetric for measurement, the wavelength of the irradiated light, and the like. Accordingly, the method needs to, for example, prepare a plurality of reference samples having different film thicknesses for each film type and, thus, the method lacks convenience.

An aspect of the present disclosure has been made in view of the circumstances, and an object of the present disclosure is to provide a film thickness measuring apparatus and a film thickness measuring method capable of easily measuring a film thickness of an object.

**Solution to Problem**

A film thickness measuring apparatus according to an aspect of the present disclosure is a film thickness measuring apparatus for measuring a film thickness of an object having a film formed on a substrate, the film thickness measuring apparatus including a light irradiation unit configured to irradiate the object with light in a planar manner, an imaging unit configured to image light from the object, a calculation unit configured to derive a measurement parameter related to the object based on a signal from the imaging unit that has imaged light, a storage unit configured to store relationship information between a film thickness and the measurement parameter, and an analysis unit configured to derive the film thickness of the object based on the relationship information and the measurement parameter related to the object determined by the calculation unit. The relationship information is derived based on theoretical reflectance according to a type of a film and spectral characteristics of the film thickness measuring apparatus.

In the film thickness measuring apparatus according to an aspect of the present disclosure, the relationship information between a film thickness and a measurement parameter is stored. Then, in the film thickness measuring apparatus, the measurement parameter is derived based on a signal from the imaging unit that images light from the object, and the film thickness of the object is derived based on the measurement parameter and the relationship information. Here, the relationship information is information derived based on the theoretical reflectance according to the type of film and the spectral characteristics of the film thickness measuring apparatus, and is information that defines the correlation between the film thickness and the measurement parameter with high accuracy in a situation where the type of film is identified. Therefore, as described above, the film thickness of the object is derived based on the measurement parameter derived based on the imaging result and the relationship information, which enables deriving the film thickness of the object with high accuracy. In the film thickness measuring apparatus according to an aspect of the present disclosure, the film thickness of the object is derived using the relationship information (information derived based on the theoretical reflectance and the spectral characteristics) acquired in advance, which eliminates the need for measuring the reference sample or the like, so that the film thickness of the object can be easily measured.

In the film thickness measuring apparatus, the storage unit stores the relationship information for each type of the film, and the analysis unit may derive the film thickness of the object based on the relationship information according to the type of the film of the object and the measurement parameter related to the object determined by the calculation unit. As described above, the relationship information is stored for each film type, and the film thickness of the object is derived based on the relationship information according to a film type of the object and the measurement parameter, which enables easily measuring the film thickness with high accuracy for objects with various types of films.

The film thickness measuring apparatus further includes an optical element having transmittance and reflectance changing according to a wavelength in a predetermined wavelength range, the optical element configured to transmit and reflect the light from the object to separate the light, in which the imaging unit may include a first camera configured to image light that has been reflected by the optical element to output a first signal, and a second camera configured to image light that has passed through the optical element to output a second signal. As described above, the light from the object is separated by the optical element having transmittance and reflectance changing according to a wavelength, and the separated light is imaged by the first camera and the second camera, so that the ratio of the transmitted light and the ratio of the reflected light can be appropriately detected and information indicating the wavelength can be identified based on the detected information. As described above, information indicating the wavelength having a high correlation with the film thickness can be identified, which increases the accuracy of measuring the film thickness.

In the film thickness measuring apparatus, the calculation unit may derive a wavelength centroid as the measurement parameter based on the first signal and the second signal. As described above, the wavelength centroid, which is the measurement parameter, is derived based on the first signal from the first camera and the second signal from the second camera to thereby increase the accuracy of measuring the film thickness using the wavelength centroid having a high correlation with the film thickness as the measurement parameter.

In the film thickness measuring apparatus, the relationship information may be a relationship equation between the film thickness and the measurement parameter derived by plotting and fitting each expected value of the measurement parameter corresponding to each film thickness derived based on the theoretical reflectance and the spectral characteristic. By using such a relationship equation as the relationship information, the film thickness of the object can be derived with high accuracy based on the relationship information defining the correlation between the film thickness and the measurement parameter with high accuracy.

In the film thickness measuring apparatus, the object has, as the film, a first film as a first layer stacked on the substrate and a second film as a second layer stacked on the first layer formed, the storage unit stores the relationship information between a film thickness of the second layer and a measurement parameter for each combination of a type and a thickness of the film of the first layer as well as a type of the film of the second layer, and the analysis unit may derive the thickness of the second film of the object based on the relationship information according to the combination of the type and the thickness of the film of the first layer corresponding to the first film of the object as well as the type of the film of the second layer corresponding to the second film, and the measurement parameter related to the object determined by the calculation unit. As described above, since the relationship information between the film thickness of the second layer and the measurement parameter is defined for each combination of the type and thickness of the film of the first layer as well as the type of the film of the second layer, the film thickness of the second film can be easily measured with high accuracy in a case where the type and thickness of the first film as the first layer, the type of the second film as the second layer, and the measurement parameter are known.

A film thickness measuring method according to an aspect of the present disclosure is a film thickness measuring method executed by a film thickness measuring apparatus for measuring a film thickness of an object having a film formed on a substrate, the film thickness measuring method including a light irradiation step of irradiating the object with light in a planar manner, an imaging step of imaging light from the object, a calculation step of deriving a measurement parameter related to the object based on a signal related to the imaging of light in the imaging step, a reading step of reading, from a storage unit configured to store relationship information between a film thickness and the measurement parameter, the relationship information, and an analysis step of deriving the film thickness of the object based on the relationship information and the measurement parameter related to the object determined in the calculation step, in which the relationship information is derived based on theoretical reflectance according to a type of a film and spectral characteristics of the film thickness measuring apparatus.

In the film thickness measuring method, the storage unit stores the relationship information for each film type, and in the analysis step, the film thickness of the object may be derived based on the relationship information according to a film type of the object and the measurement parameter related to the object determined in the calculation step.

In the film thickness measuring method, the imaging step may include imaging, by a first camera, light that has been reflected by an optical element having transmittance and reflectance changing according to a wavelength in a predetermined wavelength range, the optical element configured to transmit and reflect the light from the object to separate the light, and outputting, by the first camera, a first signal, and includes imaging, by a second camera, light that has passed through the optical element and outputting, by the second camera, a second signal.

In the film thickness measuring method, in the calculation step, a wavelength centroid may be derived as the measurement parameter based on the first signal and the second signal.

In the film thickness measuring method, the relationship information may be a relationship equation between the film thickness and the measurement parameter derived by plotting and fitting each expected value of the measurement parameter corresponding to each film thickness derived based on the theoretical reflectance and the spectral characteristics.

In the film thickness measuring method, the object has, as the film, a first film as a first layer stacked on the substrate and a second film as a second layer stacked on the first layer formed, the storage unit stores the relationship information between a film thickness of the second layer and a measurement parameter for each combination of a type and a thickness of the film of the first layer as well as a type of the film of the second layer, and in the analysis step, the thickness of the second film of the object may be derived based on the relationship information according to the combination of the type and the thickness of the film of the first layer corresponding to the first film of the object as well as the type of the film of the second layer corresponding to the second film, and the measurement parameter related to the object determined in the calculation step.

## Advantageous Effects of Invention

According to the film thickness measuring apparatus and the film thickness measuring method according to an aspect of the present disclosure, the film thickness of an object can be easily measured.

## Brief Description of Drawings

FIG. 1 is a diagram schematically illustrating a film thickness measuring apparatus according to the present embodiment.

FIG. 2 is a diagram illustrating a relationship between a characteristic of a dichroic mirror and a wavelength of light emitted from a light source.

FIG. 3 is a diagram for explaining a spectrum of light and a characteristic of an inclined dichroic mirror.

FIG. 4 is a diagram for explaining a wavelength shift according to an amount of transmitted light and an amount of reflected light.

FIG. 5 is a diagram illustrating a relationship between a wavelength and a film thickness.

FIG. 6 is a diagram schematically illustrating an example of a configuration for estimating spectral characteristics.

FIG. 7 is a diagram illustrating an example of a method for estimating spectral characteristics using the configuration illustrated in FIG. 6.

FIG. 8 is a diagram schematically illustrating an example of another configuration for estimating spectral characteristics.

FIG. 9 is a diagram for explaining derivation of an expected value of a measurement parameter.

FIG. 10 is a diagram for explaining derivation of a relationship equation by curve fitting.

FIG. 11 is a diagram for explaining derivation of a film thickness using a relationship equation.

FIGS. 12(a) to 12(c) are diagrams for explaining derivation of relationship equations relating to a measurement parameter other than a wavelength centroid.

FIG. 13 is a diagram schematically illustrating a film thickness measuring apparatus according to a modification.

FIG. 14 is a cross-sectional view schematically illustrating a sample of a multilayer film structure according to a modification.

FIG. 15(a) is a diagram illustrating distribution of wavelength centroids measured for a first layer, and FIG. 15(b) is a diagram illustrating distribution of film thicknesses for the first layer derived based on the wavelength centroids illustrated in FIG. 15(a).

FIG. 16 is a diagram illustrating distribution of wavelength centroids measured after a second layer is formed.

FIG. 17 is a diagram for explaining derivation of a second layer film thickness based on the wavelength centroids measured after the second layer is formed and a first layer film thickness.

FIG. 18 is a diagram for explaining a relationship between a second layer film thickness and a wavelength centroid for each first layer film thickness.

**Description of Embodiments**

Hereinafter, embodiments of the present disclosure will be described in detail with reference to the drawings. Note that, in the drawings, the same or corresponding parts are denoted by the same reference signs, and redundant description will be omitted.

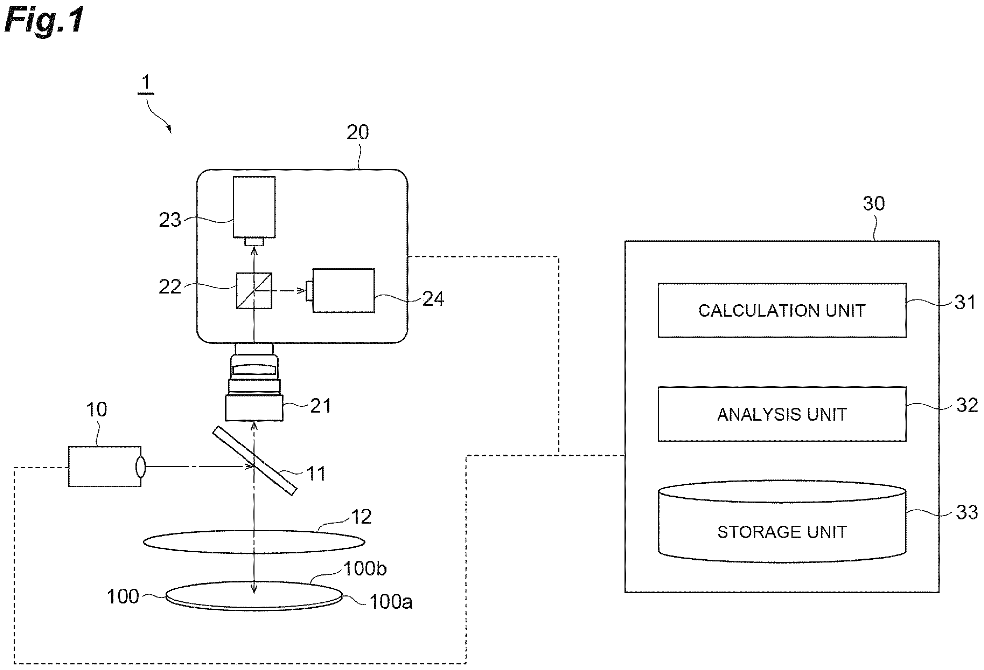

FIG. 1 is a diagram schematically illustrating a film thickness measuring apparatus 1 according to the present embodiment. The film thickness measuring apparatus 1 is an apparatus that irradiates a sample 100 (object) with light in a planar manner and measures a thickness of a film formed on the sample 100 based on light reflected from the sample 100. The sample 100 may be, for example, a light emitting element such as an LED, a mini LED, a $\mu$LED, an SLD element, a laser element, a vertical laser element (VCSEL), or an OLED, or may be a light emitting element that adjusts a light emission wavelength by a fluorescent substance including a nano dot or the like. Examples of the sample 100 include an optical film, a thin film for a display panel, and a thin film for a semiconductor. The sample 100 is an object in which a film 100b is formed on a surface of a substrate 100a. In the present embodiment, the sample 100 will be described on the assumption that only one layer of the film 100b is formed on the surface of the substrate 100a. The film 100b is, for example, an oxide film, a nitride film, or the like, but may be another film.

As illustrated in FIG. 1, the film thickness measuring apparatus 1 includes a light source 10 (light irradiation unit), a half mirror 11, a field lens 12, a camera system 20, and a control apparatus 30 (calculation unit, storage unit, analysis unit).

The light source 10 irradiates the sample 100 with light in a planar manner (light irradiation step). For example, the light source 10 planarly irradiates substantially the entire surface of the sample 100 with light. The light source 10 is, for example, a light source capable of uniformly irradiating the surface of the sample 100, and irradiates the sample 100 with diffused light. The light source 10 may be a surface lighting unit using a white LED, a halogen lamp, a Xe lamp, or the like. The light emitted from the light source 10 passes through the half mirror 11 and the field lens 12 to be applied to the sample 100 in a planar manner.

The light source 10 irradiates the sample 100 with light having a wavelength included in a predetermined wavelength range of an inclined dichroic mirror 22 (details will be described later) included in the camera system 20. Although details will be described later, the inclined dichroic mirror 22 is an optical element that separates the light from the sample 100 by transmitting and reflecting the light according to the wavelength. The transmittance and the reflectance of the inclined dichroic mirror 22 change according to the wavelength in the predetermined wavelength range described above.

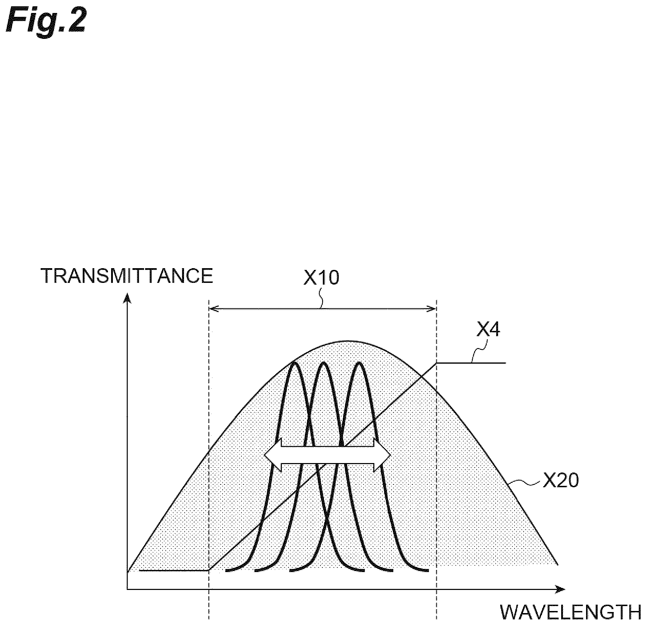

FIG. 2 is a diagram illustrating a relationship between a characteristic of the inclined dichroic mirror 22 and a wavelength of light emitted from the light source 10. In FIG. 2, the horizontal axis represents a wavelength, and the vertical axis represents transmittance of the inclined dichroic mirror 22. As illustrated in a characteristic X4 of the inclined dichroic mirror 22 of FIG. 2, in the inclined dichroic mirror 22, the transmittance (and reflectance) of the light gently changes according to a change in wavelength in a predetermined wavelength range X10, and the transmittance (and reflectance) of the light is constant regardless of a change in wavelength in a wavelength range other than the specific wavelength range. As illustrated in FIG. 2, light X20 output from the light source 10 includes light of a wavelength included in the predetermined wavelength range X10 described above. That is, the light source 10 outputs light of a broad spectrum including the predetermined wavelength range X10. Note that the wavelength range (interference peak wavelength) related to the measurement is determined based on the material of the film formed on the sample 100 and the measured film thickness range.

Returning to FIG. 1, the half mirror 11 is a mirror that reflects the light emitted from the light source 10 in the direction of the sample 100 (specifically, the direction of the field lens 12 that guides the light to the sample 100) and transmits the light (specifically, light that has passed through the field lens 12 from the sample 100) from the sample 100 irradiated with the light. The field lens 12 is a lens that aligns the traveling direction of the light.

The camera system 20 includes a lens 21, the inclined dichroic mirror 22 (optical element), an area sensor 23 (second camera, imaging unit), and an area sensor 24 (first camera, imaging unit). Note that the camera system 20 may include a linear image sensor (detection unit) instead of the area sensor.

The lens 21 is a lens condensing the light from the sample 100 which has passed through the field lens 12 and the half mirror 11 to enter the lens 21. The lens 21 may be disposed at a preceding stage (upstream) of the inclined dichroic mirror 22, or may be disposed in a region between the inclined dichroic mirror 22 and the area sensors 23 and 24. In the present embodiment, the description will be given on the assumption that the lens 21 is disposed at the preceding stage (upstream) of the inclined dichroic mirror 22. The lens 21 may be a finite focus lens or an infinite focus lens. In a case where the lens 21 is a finite focus lens, a distance from the lens 21 to the area sensors 23 and 24 is a predetermined value. In a case where the lens 21 is an infinite focus lens, the lens 21 is a collimator lens that converts light from the sample 100 into parallel light, and aberration correction is performed so as to obtain parallel light. Light output from the lens 21 is incident on the inclined dichroic mirror 22.

The inclined dichroic mirror 22 is a mirror created using a special optical material, and is an optical element that separates light from the sample 100 by transmitting and reflecting the light according to the wavelength. The inclined dichroic mirror 22 is configured such that transmittance and reflectance of light change according to a wavelength in a predetermined wavelength range.

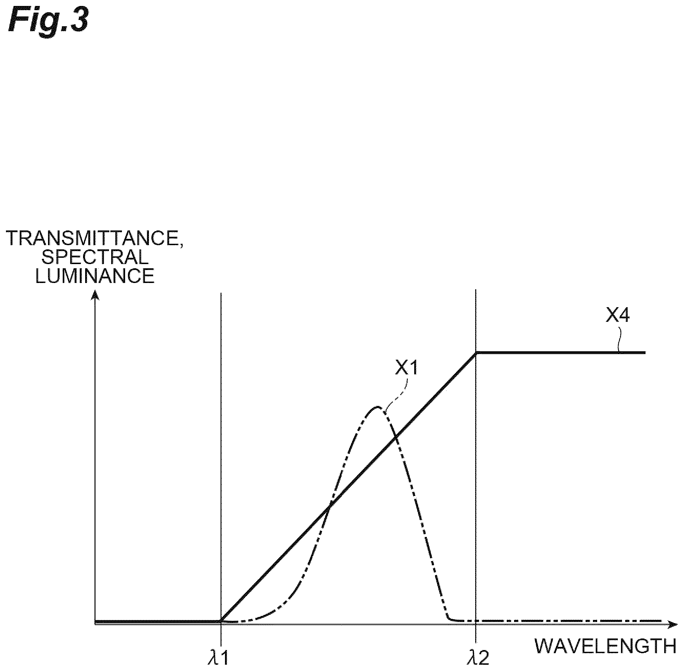

FIG. 3 is a diagram for explaining a spectrum of light and a characteristic of the inclined dichroic mirror 22. In FIG. 3, the horizontal axis represents a wavelength, and the vertical axis represents spectral intensity (in the case of the spectrum of light) and the transmittance (in the case of the inclined dichroic mirror 22). As illustrated in a characteristic X4 of the inclined dichroic mirror 22 of FIG. 3, in the inclined dichroic mirror 22, the transmittance (and reflectance) of the light gently changes according to a change in wavelength in the predetermined wavelength range (wavelength range of wavelengths $\lambda1$ to $\lambda2$). On the other hand, in a wavelength range other than the predetermined wavelength range (that is, the wavelength side lower than the wavelength $\lambda1$ and the wavelength side higher than the wavelength $\lambda2$), the transmittance (and reflectance) of light may be constant regardless of a change in wavelength. In other words, in a specific wavelength band (wavelength band of wavelengths $\lambda1$ to $\lambda2$), the transmittance of light monotonically increases (reflectance monotonically decreases) according to a change in wavelength. The transmittance and the reflectance have a negative correlation such that when one is changed in a direction in which the other is increased, the other is changed in a direction in which the other is decreased. Therefore, hereinafter, the transmittance and the reflectance may be simply described as "transmittance" instead of "transmittance (and reflectance)". Note that "the transmittance of light is constant regardless of a change in wavelength" includes not only a case where the transmittance is completely constant but also a case where a change in transmittance with respect to a change in wavelength of 1 nm is 0.1% or less, for example. On the wavelength side lower than the wavelength $\lambda1$, the transmittance of light may be approximately 0% regardless of a change in wavelength, and on the wavelength side higher than the wavelength $\lambda2$, the transmittance of light may be approximately 100% regardless of a change in wavelength. Note that "the light transmittance is approximately 0%" includes a transmittance of about 0% + 10%, and "the light transmittance is approximately 100%" includes a transmittance of about 100% - 10%. In FIG. 3, a waveform X1 indicates a waveform of light output from the light source 10. As illustrated in the waveform X1 of FIG. 3, the light output from the light source 10 includes light of a wavelength included in the predetermined wavelength range (wavelength range of wavelengths $\lambda1$ to $\lambda2$) of the inclined dichroic mirror 22.

Returning to FIG. 1, the area sensors 23 and 24 image light from the sample 100 (imaging step). The area sensors 23 and 24 image light that has been separated by the inclined dichroic mirror 22. The area sensor 23 images light that has passed through the inclined dichroic mirror 22 to output a second signal. The area sensor 24 images light that has been reflected by the inclined dichroic mirror 22 to output a first signal. The range of wavelengths in which the area sensors 23 and 24 have sensitivity corresponds to a predetermined wavelength range in which transmittance (and reflectance) of light changes according to a change in wavelength in the inclined dichroic mirror 22. The area sensors 23 and 24 are, for example, monochrome sensors or color sensors. The imaging results (images) by the area sensors 23 and 24 are output to the control apparatus 30 by the first signal and the second signal described above.

A band pass filter (not illustrated) may be disposed at a preceding stage (upstream) of the area sensors 23 and 24. Such a band pass filter (not illustrated) may be, for example, a filter that removes light in a wavelength range other than the above-described predetermined wavelength range (in the inclined dichroic mirror 22, a wavelength range in which transmittance and reflectance of light change according to a wavelength).

The control apparatus 30 is a computer, and physically includes a memory such as a RAM and a ROM, a processor (arithmetic circuit) such as a CPU, a communication interface, and a storage unit such as a hard disk. The control apparatus 30 functions by executing a program stored in the memory by the CPU of the computer system. The control apparatus 30 may include a microcomputer or an FPGA.

The control apparatus 30 derives the film thickness of the sample 100 based on the first signal and the second signal which are signals from the area sensors 23 and 24 obtained by imaging the light. The control apparatus 30 performs, as processing related to deriving the film thickness, measurement parameter deriving processing based on the signals from the area sensors 23 and 24 and film thickness deriving processing based on the measurement parameter and the like. In addition, the control apparatus 30 stores relationship information between the film thickness and the measurement parameter as the premise of performing the film thickness deriving processing. The control apparatus 30 includes a calculation unit 31, an analysis unit 32, and a storage unit 33 as functional configurations that implement the processing and storage described above. The calculation unit 31 is a function of performing the measurement parameter deriving processing. The analysis unit 32 is a function of performing the film thickness deriving processing. The storage unit 33 stores therein the relationship information described above. Hereinafter, each function will be described in detail.

The calculation unit 31 derives a measurement parameter related to the sample 100 based on signals from the area sensors 23 and 24 that have imaged light (calculation step). The measurement parameter may be any type of parameter having a correlation with the film thickness, and may be, for example, a wavelength centroid of the light from the sample 100, intensity of the light that has passed through the inclined dichroic mirror 22, intensity of the light that has been reflected by the inclined dichroic mirror 22, or a ratio between the intensity of the light that has passed through the inclined dichroic mirror 22 and the intensity of the light that has been reflected by the inclined dichroic mirror 22. In the following description, it is assumed that the measurement parameter is the wavelength centroid of the light from the sample 100.

The calculation unit 31 may derive, as the measurement parameter, the wavelength centroid of the light for each pixel based on the amount of transmitted light (the intensity of the light that has passed through the inclined dichroic mirror 22) identified based on the second signal from the area sensor 23 indicating the imaging result in the area sensor 23 and the amount of reflected light (the intensity of the light that has been reflected by the inclined dichroic mirror 22) identified based on the first signal from the area sensor 24 indicating the imaging result in the area sensor 24. Specifically, the calculation unit 31 derives the wavelength centroid of each pixel based on the following Equation (1). In the following Equation (1), x' represents the wavelength centroid, IT' represents the amount of transmitted light, and IR' represents the amount of reflected light.

$$x' = (IT' - IR')/2(IT' + IR') \quad (1)$$

The calculation unit 31 may further derive the wavelength centroid of the light for each pixel in consideration of the central wavelength (central wavelength in a predetermined wavelength range) of the inclined dichroic mirror 22 and the width of the inclined dichroic mirror 22. The width of the inclined dichroic mirror 22 is, for example, a wavelength width from a wavelength at which transmittance becomes 0% to a wavelength at which transmittance becomes 100% in the inclined dichroic mirror 22. In this case, the calculation unit 31 may derive the wavelength centroid of each pixel based on the following Equation (2). In the following Equation (2), x' represents the wavelength centroid, IT' represents the amount of transmitted light, IR' represents the amount of reflected light, $\lambda0$ represents the central wavelength of the inclined dichroic mirror 22, and A represents the width of the inclined dichroic mirror 22.

$$x' = \lambda0 + A(IT' - IR')/2(IT' + IR') \quad (2)$$

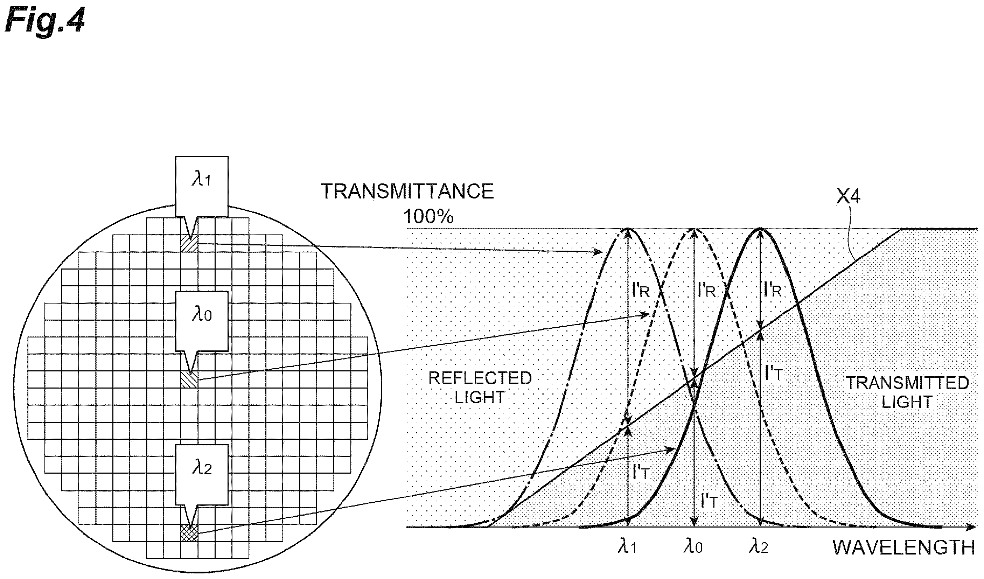

FIG. 4 is a diagram for explaining a wavelength shift according to the amount of transmitted light and the amount of reflected light. In a case where x' (the wavelength centroid) is derived by the above Equation (1) or (2), x' = $\lambda0$ (the central wavelength of the inclined dichroic mirror 22) is assumed for a pixel in which IT' (the amount of transmitted light) = IR' (the amount of reflected light), as illustrated in FIG. 4. In addition, for a pixel in which IT' < IR', that is, a pixel in which the amount of reflected light is larger than the amount of transmitted light, x' = $\lambda1$ (wavelength on a shorter wavelength side than $\lambda0$) is set. In addition, for a pixel in which IT' > IR', that is, a pixel in which the amount of transmitted light is larger than the amount of reflected light, x' = $\lambda2$ (wavelength on a longer wavelength side than $\lambda0$) is set. As described above, a value of x' (the wavelength centroid) is shifted (wavelength shift) based on the amount of transmitted light and the amount of reflected light.

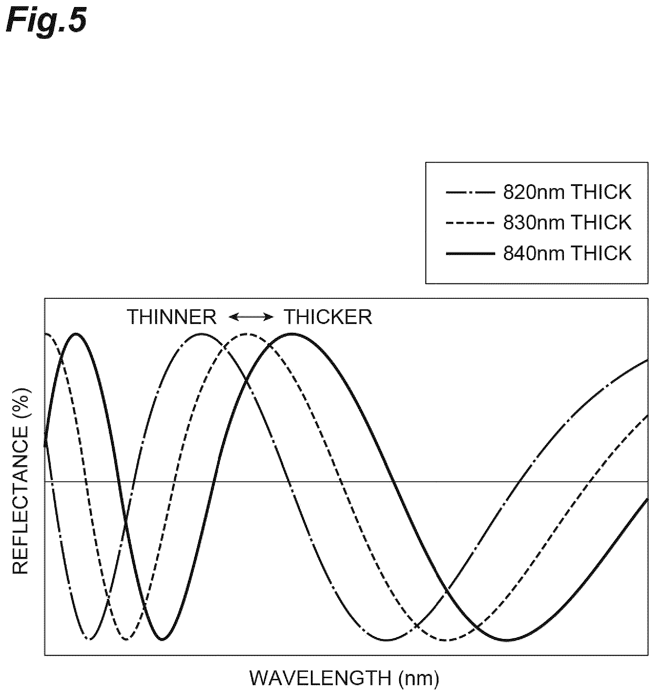

The wavelength centroid has a correlation with the film thickness and, thus, the wavelength centroid can be used to derive the film thickness. FIG. 5 is a diagram illustrating a relationship between a wavelength and a film thickness. In FIG. 5, the horizontal axis represents a wavelength, and the vertical axis represents reflectance. In the example illustrated in FIG. 5, the relationship between the wavelength and the reflectance is illustrated for each of an example in which the film thickness is 820 nm, an example in which the film thickness is 830 nm, and an example in which the film thickness is 840 nm. As illustrated in FIG. 5, the wavelength centroid differs depending on the film thickness. As described above, since the wavelength centroid has a correlation with the film thickness, the film thickness can be estimated by identifying the wavelength centroid.

Returning to FIG. 1, the storage unit 33 stores therein relationship information between the film thickness and the measurement parameter (here, the wavelength centroid). As described above, the film thickness and the wavelength centroid are correlated. Therefore, since the relationship information between the film thickness and the wavelength centroid is prepared in advance, the film thickness can be derived based on the relationship information and the wavelength centroid actually measured. The storage unit 33 stores therein the relationship information for each type of film.

The relationship information may be derived based on theoretical reflectance according to the type of film and spectral characteristics (spectral sensitivity) of the entire film thickness measuring apparatus 1. When the type of film (refractive index of the film and attenuation coefficient of the film) and the film thickness are determined, the value of the theoretical reflectance for each wavelength is determined. The spectral characteristics of the entire film thickness measuring apparatus 1 may be identified (estimated) in advance by various methods. Hereinafter, a method for estimating the spectral characteristics of the entire film thickness measuring apparatus 1 will be exemplified.

The spectral characteristics of the film thickness measuring apparatus 1 may be estimated, for example, as an accumulation of the spectral characteristics (spectral sensitivities) of optical components constituting the film thickness measuring apparatus 1. Specifically, the spectral characteristics of the film thickness measuring apparatus 1 may be estimated by accumulating the luminance spectrum of the light source 10, the spectral transmittance (transmittance spectrum) of the half mirror 11, the spectral transmittance (transmittance spectrum) of the field lens 12, the spectral transmittance (transmittance spectrum) of the lens 21, the spectral transmittance of the inclined dichroic mirror 22, the quantum efficiency (QE) or spectral sensitivity of the area sensor 23, the quantum efficiency (QE) or spectral sensitivity of the area sensor 24, and the reflectance of a bare wafer placed instead of the sample 100.

In this case, the spectral characteristic SCT_xm, yn ($\lambda$) on the transmission side that passes through the inclined dichroic mirror 22 is expressed by the following Equation (3). Further, the spectral characteristic SCR_xm, yn ($\lambda$) on the reflection side that reflects off the inclined dichroic mirror 22 is expressed by the following Equation (4). In the Equations (3) and (4), $\lambda$ represents a wavelength, xm and yn represent coordinates on the surface of the sample 100, SC1 represents a luminance spectrum of the light source 10, SC2 represents a spectral transmittance of the half mirror 11, SC3 represents a spectral transmittance of the field lens 12, SC4 represents a spectral transmittance of the lens 21, SC5 represents a spectral transmittance of the inclined dichroic mirror 22, SC6 represents a quantum efficiency or spectral sensitivity of the area sensor 23, SC7 represents a quantum efficiency or spectral sensitivity of the area sensor 24, and R represents a reflectance in the bare wafer.

$$SCT\_xm,yn(\lambda) = SC1(\lambda)xm,yn \times SC2(\lambda)xm,yn \times SC3(\lambda)xm,yn \times SC4(\lambda)xm,yn \times SC5(\lambda)xm,yn \times SC6(\lambda)xm, yn \times R(\lambda) \tag{3}$$

$$SCR\_xm,yn(\lambda) = SC1(\lambda)xm,yn \times SC2(\lambda)xm,yn \times SC3(\lambda)xm,yn \times SC4(\lambda)xm,yn \times SC5(\lambda)xm,yn \times SC7(\lambda)xm, yn \times R(\lambda) \tag{4}$$

Note that, for example, in a case where uniformity of the spectral characteristics is spatially high on the surface of the sample 100 (variation in spectral characteristics for each coordinate is small), for example, SC1 ($\lambda$) xm, yn = SC1 ($\lambda$) or the like may be used without considering the position dependence for each coordinate (the same applies to SC2 to SC7).

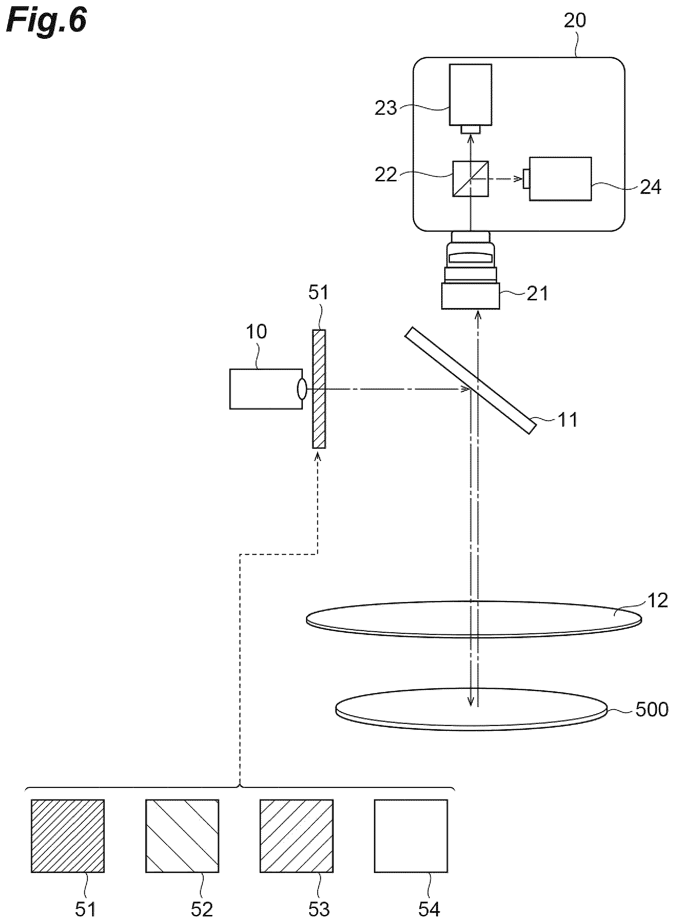

The spectral characteristics of the film thickness measuring apparatus 1 may be estimated using, for example, a plurality of types of band pass filters. FIG. 6 is a diagram schematically illustrating an example of a configuration for estimating the spectral characteristics of the film thickness measuring apparatus 1. FIG. 6 illustrates a plurality of types of band pass filters 51 to 54 in addition to each configuration included in the film thickness measuring apparatus 1 described above. For example, in a case where the rate of change in the spectrum is a continuous monotonous characteristic, the spectral characteristic SCT_xm, yn ($\lambda$) on the transmission side and the spectral characteristic SCR_xm, yn ($\lambda$) on the reflection side of the film thickness measuring apparatus 1 for each coordinate of the sample 100 can be collectively estimated while sequentially switching between the plurality of types of band pass filters 51 to 54. In this case, the spectral characteristic SCT_xm, yn ($\lambda$) on the transmission side is estimated from the amount of transmitted light measured by the area sensor 23, and the spectral characteristic SCR_xm, yn ($\lambda$) on the reflection side is estimated from the amount of reflected light measured by the area sensor 24, without individually considering the spectral characteristics of the optical components of the film thickness measuring apparatus 1. In a case where the spectral characteristics are estimated using this configuration, a bare wafer 500 is placed instead of the sample 100.

In the configuration illustrated in FIG. 6, the band pass filter 51 to 54 are filters that remove light in a wavelength range other than the predetermined wavelength range. The band pass filter 51 is, for example, a filter that removes light in a wavelength range other than a first wavelength range having the lowest wavelength. The band pass filter 52 is a filter that removes light in a wavelength range other than a second wavelength range, which is higher than the first wavelength range described above. The band pass filter 53 is a filter that removes light in a wavelength range other than a third wavelength range, which is higher than the second wavelength range described above. The band pass filter 54 is a filter that removes light in a wavelength range other than a fourth wavelength range, which is higher than the third wavelength range described above.

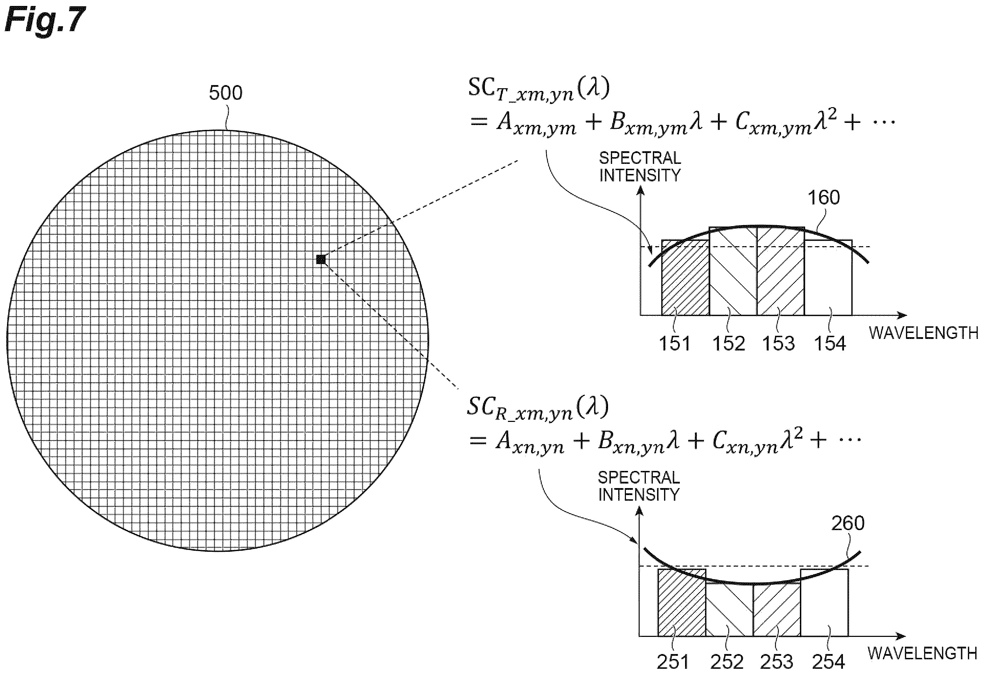

FIG. 7 is a diagram illustrating an example of a method for estimating the spectral characteristics using the configuration illustrated in FIG. 6. In FIG. 7, an image of one coordinate included in the bare wafer 500 is illustrated on the left side, the amount of transmitted light measured by the area sensor 23 with respect to that one coordinate while switching between the band pass filters 51 to 54 is illustrated on the upper right, and the amount of reflected light measured by the area sensor 24 with respect to that one coordinate while switching between the band pass filters 51 to 54 is illustrated on the lower right. In the upper right diagram and the lower right diagram of FIG. 7, the horizontal axis represents a wavelength, and the vertical axis represents a spectral intensity.

In the upper right diagram of FIG. 7, a wavelength range corresponding to the first wavelength range of the band pass filter 51 is a wavelength range 151, a wavelength range corresponding to the second wavelength range of the band pass filter 52 is a wavelength range 152, a wavelength range corresponding to the third wavelength range of the band pass filter 53 is a wavelength range 153, and a wavelength range corresponding to the fourth wavelength range of the band pass filter 54 is a wavelength range 154. As illustrated in the upper right diagram of FIG. 7, the amounts of transmitted light in the case of using the band pass filters 51 to 54 are identified, and curve fitting is performed on the data of the amounts of transmitted light for example, whereby a curve 160 indicating a relationship between the wavelength and the spectral intensity is derived. A relationship equation (polynomial) indicating such a curve 160 is a relationship equation indicating the spectral characteristic SCT_xm, yn ($\lambda$) on the transmission side. Examples of the curve fitting method include a polynomial approximation method and other curve fitting methods. A curve indicating the relationship between the wavelength and the spectral intensity may be derived using a method other than the curve fitting, an interpolation method for example.

Similarly, in the lower right diagram of FIG. 7, a wavelength range corresponding to the first wavelength range of the band pass filter 51 is a wavelength range 251, a wavelength range corresponding to the second wavelength range of the band pass filter 52 is a wavelength range 252, a wavelength range corresponding to the third wavelength range of the band pass filter 53 is a wavelength range 253, and a wavelength range corresponding to the fourth wavelength range of the band pass filter 54 is a wavelength range 254. As illustrated in the lower right diagram of FIG. 7, the amounts of transmitted light in the case of using the band pass filters 51 to 54 are identified, and curve fitting is performed on the data of the amounts of transmitted light, whereby a curve 260 indicating a relationship between the wavelength and the spectral intensity is derived. A relationship equation (polynomial) indicating such a curve 260 is a relationship equation indicating the spectral characteristic SCR_xm, yn ($\lambda$) on the reflection side. Examples of the curve fitting method include a polynomial approximation method and other curve fitting methods. A curve indicating the relationship between the wavelength and the spectral intensity may be derived using a method other than the curve fitting, an interpolation method for example. As described above, the spectral characteristics of the film thickness measuring apparatus 1 can be estimated using the band pass filter 51 to 54.

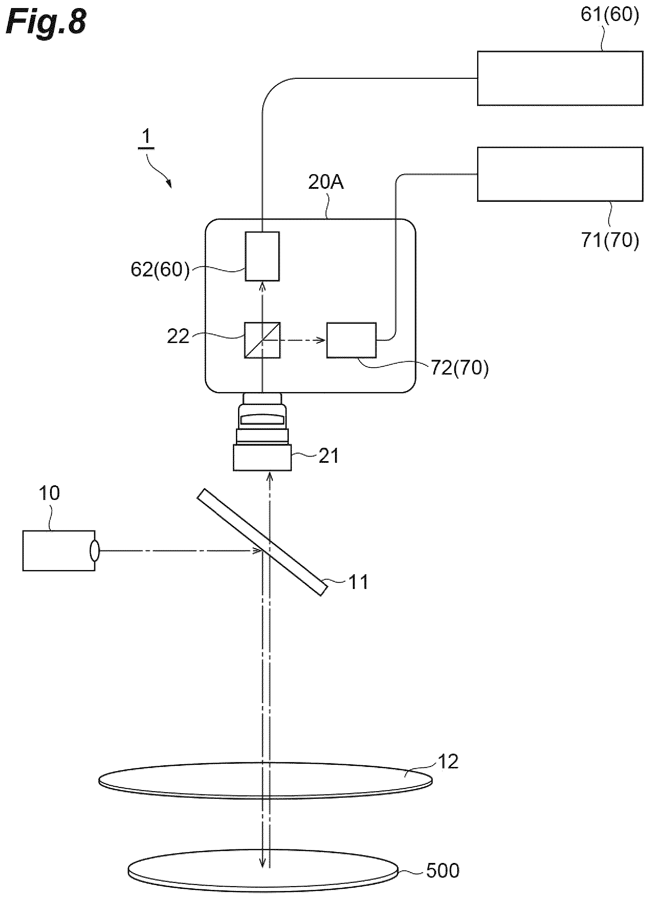

The spectral characteristics of the film thickness measuring apparatus 1 may be estimated using, for example, a spectrometer. FIG. 8 is a diagram schematically illustrating an example of another configuration for estimating the spectral characteristics of the film thickness measuring apparatus 1. FIG. 8 illustrates a configuration of the film thickness measuring apparatus 1 described above in which spectrometers 60 and 70 are provided instead of the area sensors 23 and 24.

The spectrometer 60 can derive, among the spectral characteristic SCT_xm, yn($\lambda$) on the transmission side, a spectral characteristic SC8($\lambda$) xm, yn that is an accumulation of spectral characteristics of the optical components other than SC6($\lambda$) xm, yn that is the quantum efficiency or spectral sensitivity of the area sensor 23. The spectrometer 60 includes a measurement unit 61 and a probe head 62. The spectrometer 60 spectrally disperses the light input from the probe head 62 (the light that has passed through the inclined dichroic mirror 22) for each wavelength, and derives the intensity for each wavelength in the measurement unit 61. In this way, the spectral characteristic SC8($\lambda$) xm, yn described above is derived. As indicated by the following Equation (5), the spectral characteristic SCT_xm, yn ($\lambda$) on the transmission side is indicated by the product of SC6($\lambda$) xm, yn that is the quantum efficiency or spectral sensitivity of the area sensor 23 and the spectral characteristic SC8($\lambda$) xm, yn that is the accumulation of the spectral characteristics of the optical components.

$$\text{SCT\_xm,yn}(\lambda) = \text{SC6}(\lambda)\text{xm,yn} \times \text{SC8}(\lambda)\text{xm,yn} \quad (5)$$

Similarly, the spectrometer 70 can derive, among the spectral characteristic SCR_xm, yn($\lambda$) on the reflection side, a spectral characteristic SC9($\lambda$) xm, yn that is an accumulation of spectral characteristics of the optical components other than SC7($\lambda$) xm, yn that is the quantum efficiency or spectral sensitivity of the area sensor 24. The spectrometer 70 includes a measurement unit 71 and a probe head 72. The spectrometer 70 spectrally disperses the light input from the probe head 72 (the light that has been reflected off the inclined dichroic mirror 22) for each wavelength, and derives the intensity for each wavelength in the measurement unit 71. In this way, the spectral characteristic SC9($\lambda$) xm, yn described above is derived. As indicated by the following Equation (6), the spectral characteristic SCR_xm, yn ($\lambda$) on the reflection side is indicated by the product of SC7($\lambda$) xm, yn that is the quantum efficiency or spectral sensitivity of the area sensor 24 and the spectral characteristic SC9($\lambda$) xm, yn that is the accumulation of the spectral characteristics of the optical components.

$$\text{SCR\_xm,yn}(\lambda) = \text{SC7}(\lambda)\text{xm,yn} \times \text{SC9}(\lambda)\text{xm,yn} \quad (6)$$

In the above description, a plurality of examples of estimating the spectral characteristics of the film thickness measuring apparatus 1 using the film thickness measuring apparatus 1 has been given, but the estimation of the spectral characteristics of the film thickness measuring apparatus 1 does not necessarily have to be performed in the film thickness measuring apparatus 1. That is, it is only required that the storage unit 33 stores therein the relationship information described above, and the spectral characteristics of the film thickness measuring apparatus 1 used for deriving the relationship information may be obtained in any manner.

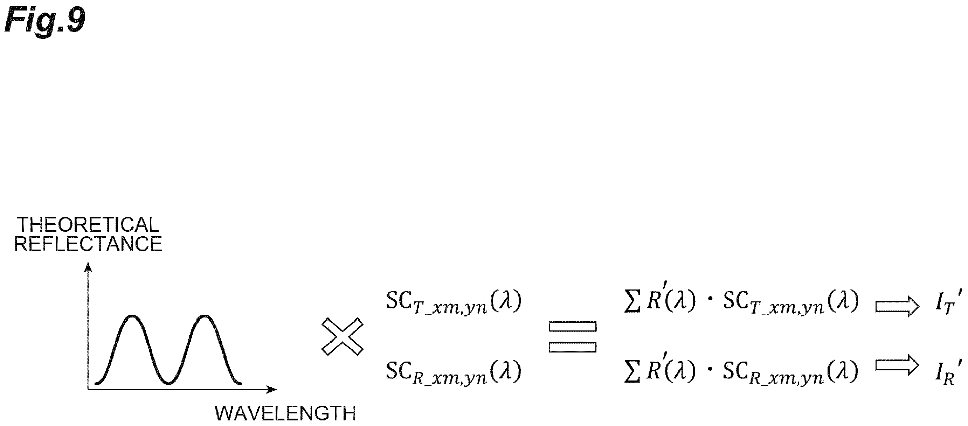

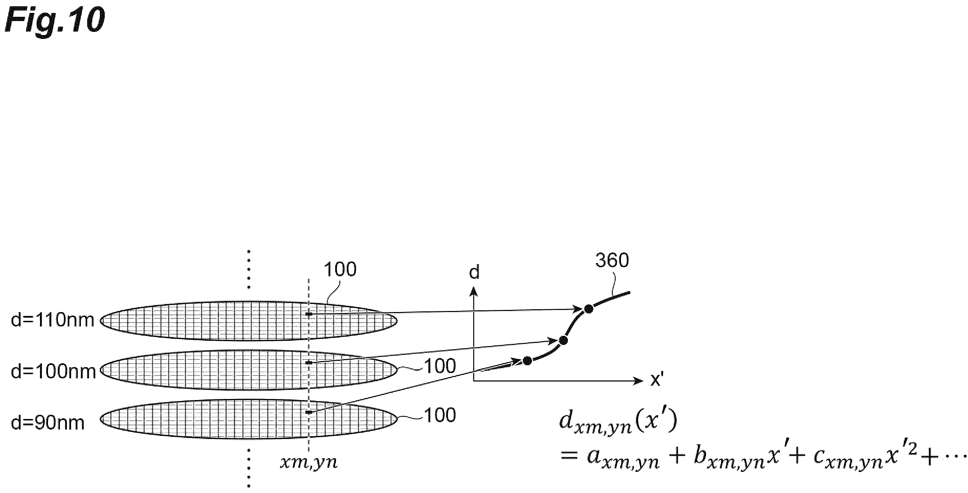

As described above, the relationship information between the film thickness and the wavelength centroid is derived based on the theoretical reflectance according to the type of film and the spectral characteristics of the film thickness measuring apparatus 1. Specifically, the relationship information is derived by deriving an expected value of the wavelength centroid (measurement parameter) based on the theoretical reflectance and the spectral characteristics of the film thickness measuring apparatus 1 (see FIG. 9) and deriving a relationship equation by curve fitting after plotting the expected value of the wavelength centroid (see FIG. 10). Hereinafter, an example of deriving the relationship information between the film thickness and the wavelength centroid for a certain film type will be described.

FIG. 9 is a diagram for explaining derivation of an expected value of a wavelength centroid, which is a measurement parameter. Here, the type of film is fixed and, thus, the value of the theoretical reflectance for each wavelength is determined according to the film thickness. It is assumed that a certain film thickness is designated and the value of the theoretical reflectance R' for each wavelength is determined. In this case, the expected value of the amount of transmitted light IT' measured by the area sensor 23 can be estimated based on the theoretical reflectance R' for each wavelength and the spectral characteristic $SCT\_xm,yn(\lambda)$ on the transmission side of the film thickness measuring apparatus 1 for each wavelength. Since the area sensor 23 does not have a spectral function, the expected value of the amount of transmitted light IT' measured by the area sensor 23 is a value obtained by integrating the intensity of light for each wavelength. Similarly, the expected value of the amount of reflected light IR' measured by the area sensor 24 can be estimated based on the theoretical reflectance R' for each wavelength and the spectral characteristic $SCR\_xm,yn(\lambda)$ on the reflection side of the film thickness measuring apparatus 1 for each wavelength. Then, the expected value of the wavelength centroid x' can be derived from the expected value of the amount of transmitted light IT' and the expected value of the amount of reflected light IR' using Equation (1) or (2) mentioned above. As described above, in a state where the type of film is fixed, an expected value of the wavelength centroid x' at a certain film thickness can be derived. Then, the expected value of the wavelength centroid x' at each film thickness is derived while changing the film thickness condition with the same film type. As a result, for a certain film type, an expected value of the wavelength centroid x' for each of a plurality of film thickness conditions is derived.

FIG. 10 is a diagram for explaining derivation of a relationship equation by curve fitting. Here, an expected value of the wavelength centroid x' for each of a plurality of film thickness conditions is derived for a certain film type. For example, in the example illustrated in FIG. 10, an expected value of the wavelength centroid x' at each of three film thickness patterns (film thickness d=90 nm, 100 nm, 110 nm) is plotted on a graph with the horizontal axis representing the wavelength centroid x' and the vertical axis representing the film thickness d. In practice, more expected values of the wavelength centroid x' with different film thickness conditions are plotted. Then, curve fitting is performed on each set of plotted data to thereby derive a curve 360 indicating a relationship between the film thickness d and the wavelength centroid x'. The relationship equation indicating such a curve 360 is a relationship equation between the film thickness and the measurement parameter. The relationship equation between the film thickness and the measurement parameter is expressed by a polynomial, for example, as in the following Equation (7). When the wavelength centroid x' is input after each parameter (a, b, c, ...) of the polynomial is obtained, the film thickness d can be derived.

$$dxm,yn(x') = axm,yn + bxm,ynx' + cxm,ynx'2 +.. \quad (7)$$

Returning to FIG. 1, the storage unit 33 stores, as the relationship information described above, the relationship equation between the film thickness and the wavelength centroid as indicated by the Equation (7). In this case, the relationship information is a relationship equation between the film thickness and the wavelength centroid derived by plotting and fitting each expected value of the wavelength centroid corresponding to each film thickness derived based on the theoretical reflectance and the spectral characteristics of the film thickness measuring apparatus 1. The storage unit 33 stores therein such a relationship equation for each type of film.

The analysis unit 32 derives the film thickness of the sample 100 based on the relationship equation between the film thickness and the wavelength centroid stored in the storage unit 33 as the relationship information, and the wavelength centroid which is the measurement parameter regarding the sample 100 obtained by the calculation unit 31. The analysis unit 32 derives the film thickness of the sample 100 based on the relationship equation corresponding to the film type of the sample 100 and the wavelength centroid obtained by the calculation unit 31 (analysis step). That is, the analysis unit 32 reads the relationship equation corresponding to the film type of the sample 100 from the storage unit 33 (reading step), and inputs the wavelength centroid obtained by the calculation unit 31 to the wavelength centroid x' of the relationship equation as indicated in Equation (7), thereby deriving the film thickness d of the sample 100.

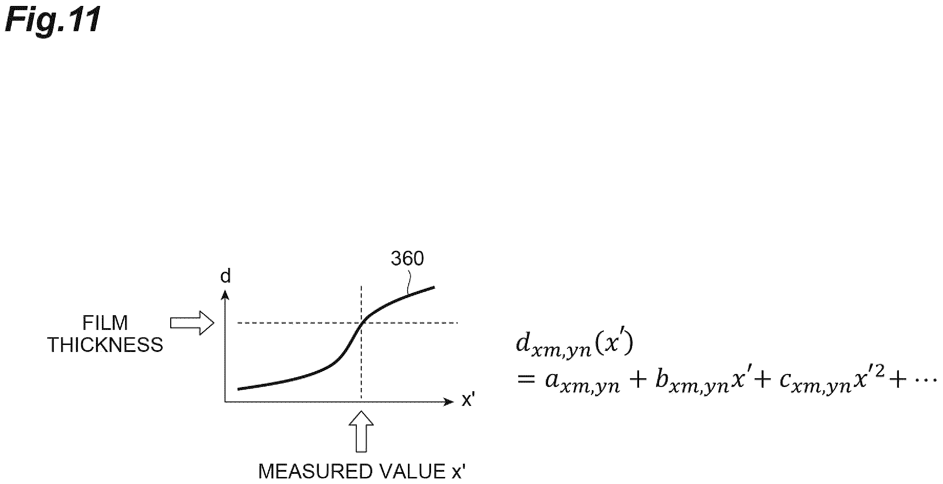

FIG. 11 is a diagram for explaining derivation of a film thickness using a relationship equation. As illustrated in FIG. 11, in a case where the curve 360 indicating the relationship between the film thickness d and the wavelength centroid x' is derived and the Equation (7) is derived, the value of the film thickness d can be uniquely derived based on the value of the wavelength centroid x' obtained by the calculation unit 31.

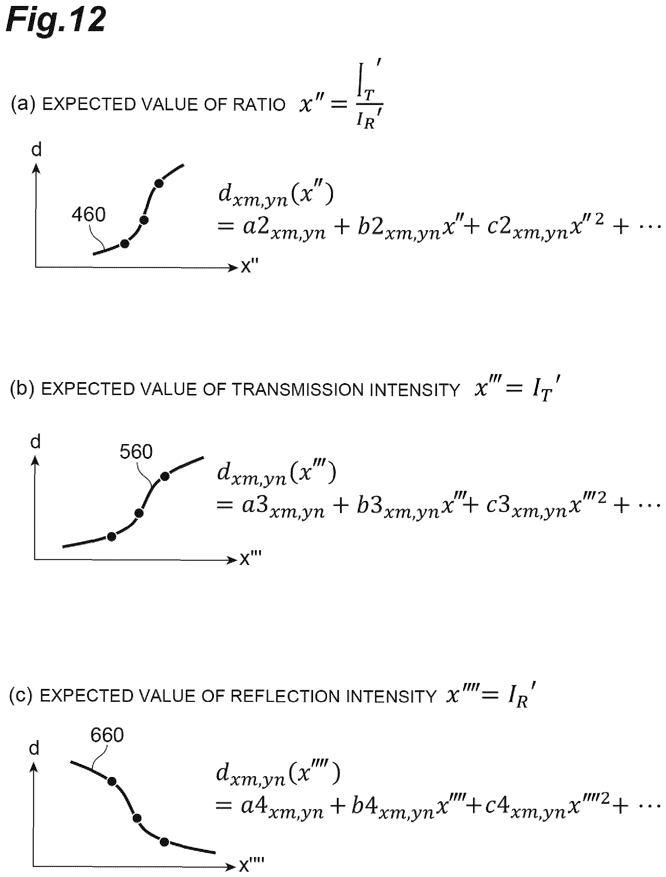

As described above, the measurement parameter may be various parameters other than the wavelength centroid x' which have a correlation with the film thickness. FIGS. 12(a) to 12(c) are diagrams for explaining derivation of relationship equations relating to a measurement parameter other than a wavelength centroid.

FIG. 12(a) is a diagram for explaining derivation of a relationship equation for a case where a ratio (ratio) between the amount of transmitted light IT' measured by the area sensor 23 and the amount of reflected light IR' measured by the area sensor 24 is set as the measurement parameter. An expected value x" of the ratio is derived by the following Equation (8).

$$x" = IT'/IR' \qquad (8)$$

A plurality of expected values x" of the ratio is derived while changing the film thickness conditions for the same film type, the expected values x" of the ratio are plotted, and curve fitting is performed, so that a curve 460 indicating the relationship between the film thickness d and the ratio x" is derived, and a relationship equation indicated in the following Equation (9) representing the curve 460 is derived.

$$dxm,yn(x") = axm,yn + bxm,ynx" + cxm,ynx"2 +.. \qquad (9)$$

Similarly, in a case where the amount of transmitted light IT' is set as the measurement parameter, a plurality of expected values x''' of the amount of transmitted light IT' is derived while changing the film thickness conditions for the same film type, the expected values x''' of the amount of transmitted light IT' are plotted, and curve fitting is performed, so that a curve 560 indicating the relationship between the film thickness d and the amount of transmitted light x''' is derived (see FIG. 12(b)), and a relationship equation indicated in the following Equation (10) representing the curve 560 is derived.

$$dxm,yn(x''') = axm,yn + bxm,ynx''' + cxm,ynx'''2 +.. \qquad (10)$$

Similarly, in a case where the amount of reflected light IR' is set as the measurement parameter, a plurality of expected values x'''' of the amount of reflected light IR' is derived while changing the film thickness conditions for the same film type, the expected values x'''' of the amount of reflected light IR' are plotted, and curve fitting is performed, so that a curve 660 indicating the relationship between the film thickness d and the amount of reflected light x'''' is derived (see FIG. 12(c), and a relationship equation indicated in the following Equation (11) representing the curve 660 is derived.

$$dxm,yn(x'''') = axm,yn + bxm,ynx'''' + cxm,ynx''''2 +.. \qquad (11)$$

Next, functional effects of the film thickness measuring apparatus 1 according to the present embodiment will be described.

The film thickness measuring apparatus 1 according to the present embodiment is a film thickness measuring apparatus that measures a film thickness of the sample 100 in which the film 100b is formed on the substrate 100a, and includes the light source 10 configured to irradiate the sample 100 with light in a planar manner, the area sensors 23 and 24 configured to image light from the sample 100, the calculation unit 31 configured to derive a measurement parameter related to the sample 100 based on signals from the area sensors 23 and 24, the storage unit 33 configured to store relationship information between the film thickness and the measurement parameter, and the analysis unit 32 configured to derive the film thickness of the sample 100 based on the relationship information and the measurement parameter related to the sample 100 obtained by the calculation unit 31. The relationship information is derived based on the theoretical reflectance according to the type of film and the spectral characteristics of the entire film thickness measuring apparatus 1.

In the film thickness measuring apparatus 1 according to the present embodiment, the relationship information between a film thickness and a measurement parameter is stored. Then, in the film thickness measuring apparatus 1, the measurement parameter is derived based on signals from the area sensors 23 and 24 that image light from the sample 100, and the film thickness of the sample 100 is derived based on the measurement parameter and the relationship information. Here, the relationship information is information derived based on the theoretical reflectance according to the type of film and the spectral characteristics of the entire film thickness measuring apparatus 1, and is information that defines the correlation between the film thickness and the measurement parameter with high accuracy in a situation where the type of film is identified. Therefore, as described above, the film thickness of the sample 100 is derived based on the measurement parameter derived based on the imaging result and the relationship information, so that the film thickness of the sample 100 can be derived with high accuracy. In the film thickness measuring apparatus 1 according to the present embodiment, the film thickness of the sample 100 is derived using the relationship information (information derived based on the theoretical reflectance and the spectral characteristic) acquired in advance, which eliminates the need for making measurement or the like on the reference sample for perceiving the relationship between the film thickness and the measurement parameter, so that the film thickness of the sample 100 can be easily measured.

The storage unit 33 stores therein the relationship information for each film type, and the analysis unit 32 may derive the film thickness of the sample 100 based on the relationship information according to the film type of the sample 100 and the measurement parameter regarding the sample 100 determined by the calculation unit 31. As described above, the relationship information is stored for each type of film, and the film thickness of the sample 100 is derived based on the relationship information according to the type of film of the sample 100 and the measurement parameter, which enables easily measuring the film thickness with high accuracy for the samples 100 with various types of films.

The film thickness measuring apparatus 1 further includes the inclined dichroic mirror 22 that has transmittance and reflectance changing according to a wavelength in a predetermined wavelength range, and passes and reflects the light from the sample 100 to separate the light. The area sensor 24 images the light that has been reflected by the inclined dichroic mirror 22 to output the first signal. The area sensor 23 images the light that has passed through the inclined dichroic mirror 22 to output the second signal. As described above, the light from the sample 100 is separated by the inclined dichroic mirror 22 having transmittance and reflectance changing according to a wavelength, and the separated light is imaged by the area sensors 23 and 24, so that the ratio of the transmitted light and the ratio of the reflected light can be appropriately detected and information indicating the wavelength can be identified based on the detected information. As described above, information indicating the wavelength having a high correlation with the film thickness can be identified, which increases the accuracy of measuring the film thickness.

The calculation unit 31 may derive the wavelength centroid as the measurement parameter based on the first signal and the second signal. This increases the accuracy of measuring the film thickness using the wavelength centroid having a high correlation with the film thickness as the measurement parameter.

The relationship information may be a relationship equation between the film thickness and the measurement parameter derived by plotting and fitting each expected value of the measurement parameter corresponding to each film thickness derived based on the theoretical reflectance and the spectral characteristics. By using such a relationship equation as the relationship information, the film thickness of the sample 100 can be derived with high accuracy based on the relationship information defining the correlation between the film thickness and the measurement parameter with high accuracy.

Although the embodiments of the present disclosure have been described above, the present disclosure is not limited to the embodiments. For example, according to the above description, in the film thickness measuring apparatus 1 of the embodiment, the area sensors 23 and 24 image the light that has been transmitted and reflected by the inclined dichroic mirror 22 to derive the measurement parameters and then to derive the film thickness. The present disclosure is not limited to such an aspect, and for example, the film thickness of the object can be measured by a film thickness measuring apparatus without the inclined dichroic mirror 22.

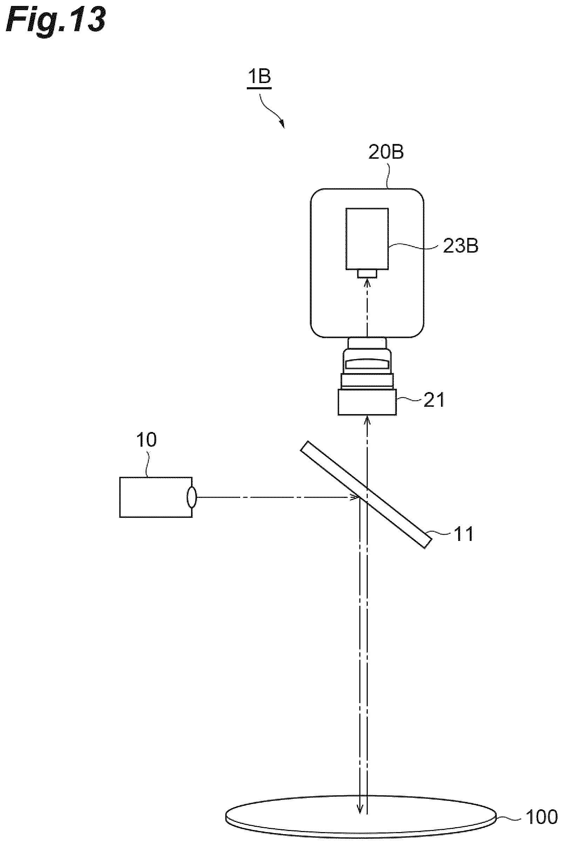

FIG. 13 is a diagram schematically illustrating a film thickness measuring apparatus 1B according to a modification. In FIG. 13, the control apparatus 30 (calculation unit, storage unit, analysis unit) is not illustrated. As illustrated in FIG. 13, the film thickness measuring apparatus 1B includes a camera system 20B instead of the camera system 20 of the film thickness measuring apparatus 1. The camera system 20B has no inclined dichroic mirror, and has only one area sensor. That is, the camera system 20B includes the lens 21 and one area sensor 23B. In such a configuration, the area sensor 23B can measure the amount of light (the intensity of light from the sample 100). Accordingly, for example, the relationship equation indicating the relationship between the amount of light and the film thickness is stored in advance as the relationship information described above, which allows the film thickness to be derived based on the relationship equation and the measured amount of light. In this case also, the relationship equation (relationship information) is derived based on the theoretical reflectance according to the type of film and the spectral characteristics of the entire film thickness measuring apparatus 1B.

In the embodiment, the example of measuring the film thickness of the sample 100 in which only one layer of the film 100b is formed on the surface of the substrate 100a has been described, but the present disclosure is not limited thereto, and the film thickness of a sample having a multilayer film structure in which two or more layers of film are formed on the surface of the substrate may be measured.

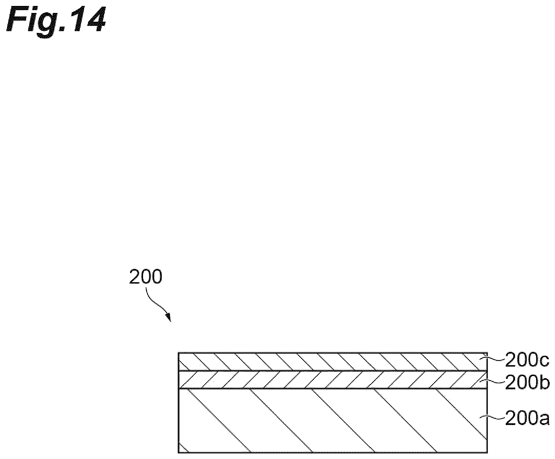

FIG. 14 is a cross-sectional view schematically illustrating a sample of a multilayer film structure according to a modification. As illustrated in FIG. 14, a sample 200 includes a substrate 200a, a film 200b (first film), and a film 200c (second film). The film 200b is a first layer stacked on the substrate 200a. The film 200c is a second layer stacked on the film 200b. Here, the description will be given assuming that the film 200b is a silicon dioxide ($SiO_2$) film and the film 200c is a silicon nitride (SiN) film, but the types of films are not limited thereto.

Hereinafter, an example of a procedure for measuring the film thickness of the sample 200 having the multilayer film structure as illustrated in FIG. 14 will be described. Such film thickness measurement includes a first layer deriving process, a second layer forming process, a wavelength centroid deriving process after the second layer formation, and a second layer deriving process. These processes are performed in sequence.

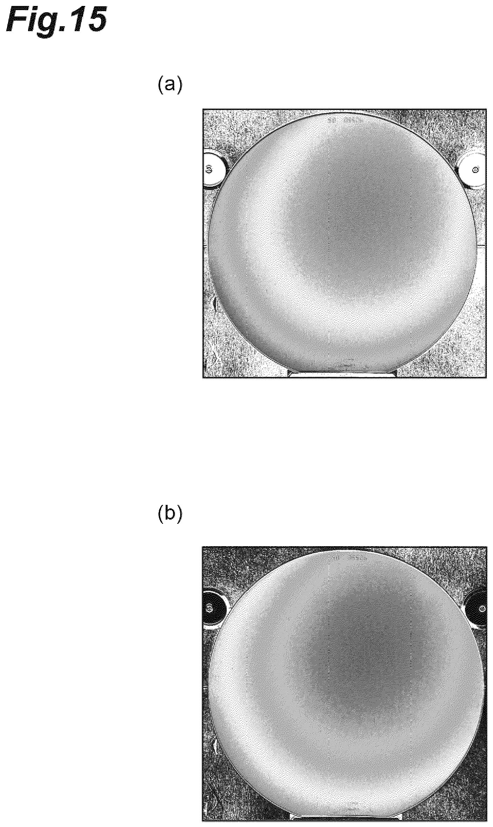

In the first layer deriving process, a sample in which only the film 200b as the first layer is formed is prepared, and the film thickness of the sample is measured (that is, the film thickness measurement on the film 200b) and evaluated. The film thickness of only the first layer can be derived by the method described in the embodiment. FIG. 15(a) is a diagram illustrating distribution of wavelength centroids measured for the first layer, and FIG. 15(b) is a diagram illustrating distribution of film thicknesses for the first layer derived based on the wavelength centroids illustrated in FIG. 15(a). As described above, when the distribution of wavelength centroids of the first layer is derived using the method described in the embodiment, the distribution of film thicknesses of the first layer can be derived.

The second layer forming process is performed following the first layer deriving process. In the second layer forming process, the film 200c as the second layer is formed so as to be stacked on the film 200b. Thereby, the sample 200 as illustrated in FIG. 14 is completed.

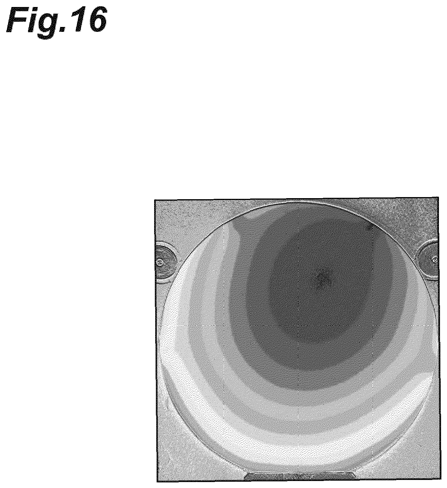

The wavelength centroid deriving process after the second layer formation is performed following the second layer forming process. In the wavelength centroid deriving process after the second layer formation, the wavelength centroid after the second layer formation is derived based on the imaging result of the light from the sample 200, similarly to the wavelength centroid derivation in the embodiment. FIG. 16 is a diagram illustrating distribution of wavelength centroids measured after the second layer is formed.

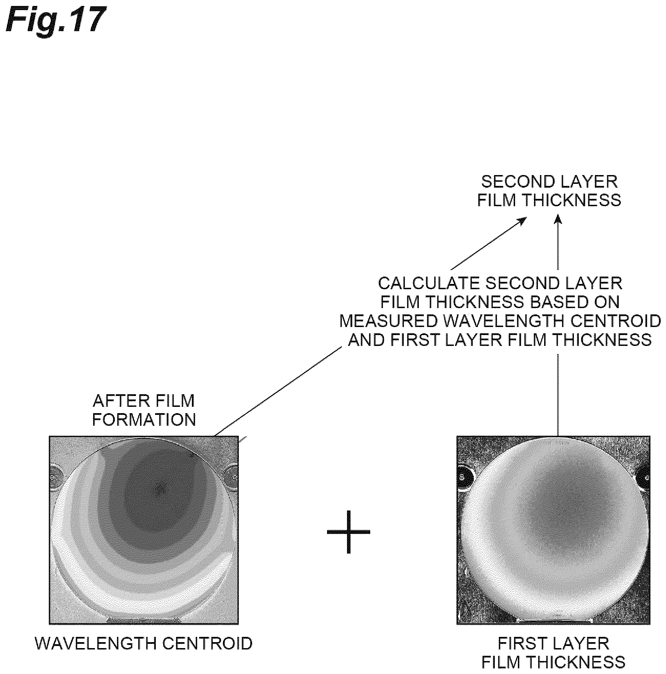

The second layer deriving process is performed following the wavelength centroid deriving process after the second layer formation. FIG. 17 is a diagram for explaining derivation of a second layer film thickness based on the wavelength centroid measured after the second layer is formed and the film thickness of the first layer. As illustrated in FIG. 17, in the second layer deriving process, the film thickness of the second layer is derived based on the wavelength centroid after the second layer formation measured (derived) in the wavelength centroid deriving process after the second layer formation and the film thickness of the first layer measured (derived) in the first layer deriving process.

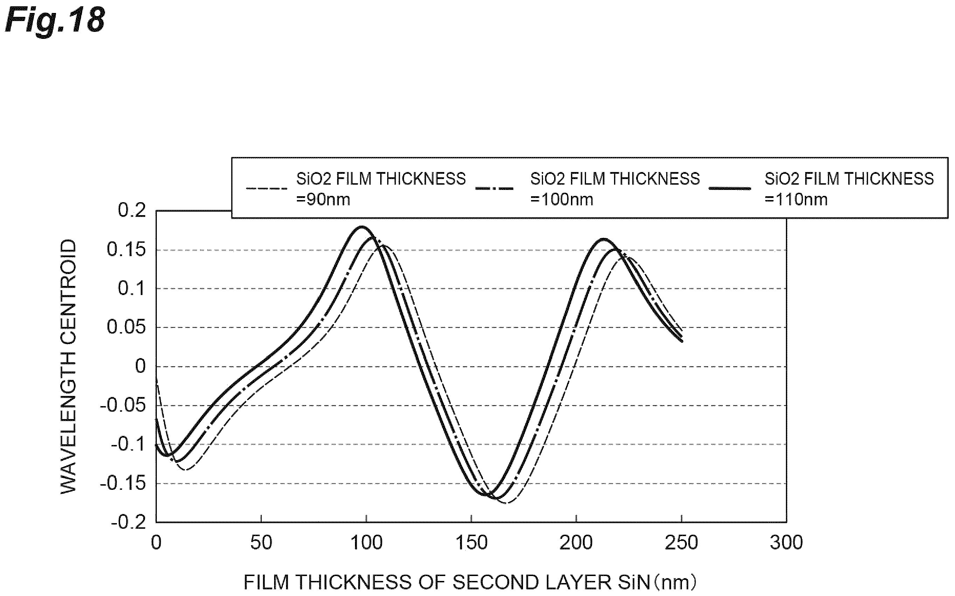

As the premise of performing the second layer deriving process, the storage unit 33 stores relationship information between the film thickness of the second layer and the wavelength centroid (measurement parameter) for each combination of the type and thickness of the film of the first layer as well as the type of the film of the second layer. FIG. 18 is a diagram for explaining a relationship between a second layer film thickness and a wavelength centroid for each of the first layer film thicknesses. In FIG. 18, the "SiO2 film thickness" indicates the film thickness of the first layer. As illustrated in FIG. 18, the relationship between the film thickness of the second layer and the wavelength centroid changes depending on the film thickness of the first layer. Accordingly, since the relationship information (see FIG. 18) between the film thickness of the second layer and the wavelength centroid is stored in advance for each combination of the type and thickness of the film of the first layer as well as the type of the film of the second layer, the film thickness of the first layer can be measured with high accuracy.

The analysis unit 32 derives the film thickness of the film 200c of the sample 200 based on the relationship information according to the combination of the type and thickness of the film 200b of the sample 200 as well as the type of the film 200c, and the wavelength centroid related to the sample 200 obtained by the calculation unit 31.

As described above, since the relationship information between the film thickness of the second layer and the measurement parameter is defined for each combination of the type and thickness of the film of the first layer as well as the type of the film of the second layer, the film thickness of the film 200c can be easily measured with high accuracy in a case where the type and thickness of the film 200b as the first layer, the type of the film 200c as the second layer, and the wavelength centroid are known.

Finally, various exemplary embodiments included in the present disclosure are described in the following [E1] to [E7].

[E1]

A film thickness measuring apparatus for measuring a film thickness of an object having a film formed on a substrate, the film thickness measuring apparatus including:

a light irradiation unit configured to irradiate the object with light in a planar manner;
an imaging unit configured to image light from the object;
a calculation unit configured to derive a measurement parameter related to the object based on a signal from the imaging unit that has imaged light;
a storage unit configured to store relationship information between a film thickness and the measurement parameter; and
an analysis unit configured to derive the film thickness of the object based on the relationship information and the measurement parameter related to the object determined by the calculation unit, in which
the relationship information is derived based on theoretical reflectance according to a type of a film and spectral characteristics of the film thickness measuring apparatus.

[E2]

The film thickness measuring apparatus according to [E1], in which the storage unit stores the relationship information for each type of the film, and

the analysis unit derives the film thickness of the object based on the relationship information according to the type of the film of the object and the measurement parameter related to the object determined by the calculation unit.

[E3]

The film thickness measuring apparatus according to [E1] or [E2], further including an optical element having transmittance and reflectance changing according to a wavelength in a predetermined wavelength range, the optical element configured to transmit and reflect the light from the object to separate the light, in which

the imaging unit includes a first camera configured to image light that has been reflected by the optical element to output a first signal, and a second camera configured to image light that has passed through the optical element to output a second signal.

[E4]

The film thickness measuring apparatus according to [E3], in which the calculation unit derives a wavelength centroid as the measurement parameter based on the first signal and the second signal.

[E5]

The film thickness measuring apparatus according to any one of [E1] to [E4], in which the relationship information is a relationship equation between the film thickness and the measurement parameter derived by plotting and fitting each expected value of the measurement parameter corresponding to each film thickness derived based on the theoretical reflectance and the spectral characteristics.

[E6]

The film thickness measuring apparatus according to any one of [E1] to [E5], in which the object has, as the film, a first film as a first layer stacked on the substrate and a second film as a second layer stacked on the first layer formed,

the storage unit stores the relationship information between a film thickness of the second layer and a measurement parameter for each combination of a type and a thickness of the film of the first layer as well as a type of the film of the second layer, and
the analysis unit derives the thickness of the second film of the object based on the relationship information according to the combination of the type and the thickness of the film of the first layer corresponding to the first film of the object as well as the type of the film of the second layer corresponding to the second film, and the measurement parameter related to the object determined by the calculation unit.

[E7]

A film thickness measuring method executed by a film thickness measuring apparatus for measuring a film thickness of an object having a film formed on a substrate, the film thickness measuring method including:

a light irradiation step of irradiating the object with light in a planar manner;
an imaging step of imaging light from the object;
a calculation step of deriving a measurement parameter related to the object based on a signal related to the imaging of light in the imaging step;
a reading step of reading, from a storage unit configured to store relationship information between a film thickness and the measurement parameter, the relationship information; and
an analysis step of deriving the film thickness of the object based on the relationship information and the measurement parameter related to the object determined in the calculation step, in which
the relationship information is derived based on theoretical reflectance according to a type of a film and spectral characteristics of the film thickness measuring apparatus.

[E8]

The film thickness measuring method according to [E7], in which the storage unit stores the relationship information for each type of the film, and

in the analysis step, the film thickness of the object is derived based on the relationship information according to the type of the film of the object and the measurement parameter related to the object determined in the calculation step.

[E9]

The film thickness measuring method according to [E7] or [E8], in which the imaging step includes imaging, by a first camera, light that has been reflected by an optical element having transmittance and reflectance changing according to a wavelength in a predetermined wavelength range, the optical element configured to transmit and reflect the light from the object to separate the light, and outputting, by the first camera, a first signal, and includes imaging, by a second camera, light that has passed through the optical element and outputting, by the second camera, a second signal.

[E10]

The film thickness measuring method according to [E9], in which, in the calculation step, a wavelength centroid is derived as the measurement parameter based on the first signal and the second signal.

[E11]

The film thickness measuring method according to any one of [E7] to [E10], in which the relationship information is a relationship equation between the film thickness and the measurement parameter derived by plotting and fitting each expected value of the measurement parameter corresponding to each film thickness derived based on the theoretical reflectance and the spectral characteristics.

[E12]

The film thickness measuring method according to any one of [E7] to [E11], in which the object has, as the film, a first film as a first layer stacked on the substrate and a second film as a second layer stacked on the first layer formed,

the storage unit stores the relationship information between a film thickness of the second layer and a measurement parameter for each combination of a type and a thickness of the film of the first layer as well as a type of the film of the second layer, and
in the analysis step, the thickness of the second film of the object is derived based on the relationship information according to the combination of the type and the thickness of the film of the first layer corresponding to the first film of the object as well as the type of the film of the second layer corresponding to the second film, and the measurement parameter related to the object determined in the calculation step. Reference Signs List

| | |
|---|---|
| 1, 1B | Film thickness measuring apparatus |
| 10 | Light source (light irradiation unit) |
| 22 | Inclined dichroic mirror (optical element) |
| 23 | Area sensor (second camera, imaging unit) |
| 23B | Area sensor (imaging unit) |
| 24 | Area sensor (first camera, imaging unit) |
| 31 | Calculation unit |
| 32 | Analysis unit |
| 33 | Storage Unit |
| 100, 200 | Sample (object) |
| 100a, 200a | Substrate |
| 100b | Film |
| 200b | Film (first film) |
| 200c | Film (second film) |

**Claims**

1. A film thickness measuring apparatus for measuring a film thickness of an object having a film formed on a substrate, the film thickness measuring apparatus comprising:

   a light irradiation unit configured to irradiate the object with light in a planar manner;
   an imaging unit configured to image light from the object;
   a calculation unit configured to derive a measurement parameter related to the object based on a signal from the imaging unit that has imaged light;
   a storage unit configured to store relationship information between a film thickness and the measurement parameter; and
   an analysis unit configured to derive the film thickness of the object based on the relationship information and the measurement parameter related to the object determined by the calculation unit, wherein
   the relationship information is derived based on theoretical reflectance according to a type of a film and spectral characteristics of the film thickness measuring apparatus.

2. The film thickness measuring apparatus according to claim 1, wherein the storage unit stores the relationship information for each type of the film, and
   the analysis unit derives the film thickness of the object based on the relationship information according to the type of the film of the object and the measurement parameter related to the object determined by the calculation unit.

3. The film thickness measuring apparatus according to claim 1 or 2, further comprising an optical element having transmittance and reflectance changing according to a wavelength in a predetermined wavelength range, the optical element configured to transmit and reflect the light from the object to separate the light, wherein
   the imaging unit includes a first camera configured to image light that has been reflected by the optical element to output a first signal, and a second camera configured to image light that has passed through the optical element to output a second signal.

4. The film thickness measuring apparatus according to claim 3, wherein the calculation unit derives a wavelength centroid as the measurement parameter based on the first signal and the second signal.

5. The film thickness measuring apparatus according to claim 1 or 2, wherein the relationship information is a relationship equation between the film thickness and the measurement parameter derived by plotting and fitting each expected value of the measurement parameter corresponding to each film thickness derived based on the theoretical reflectance and the spectral characteristics.

6. The film thickness measuring apparatus according to claim 2, wherein the object has, as the film, a first film as a first layer stacked on the substrate and a second film as a second layer stacked on the first layer formed,

   the storage unit stores the relationship information between a film thickness of the second layer and a measurement parameter for each combination of a type and a thickness of the film of the first layer as well as a type of the film of the second layer, and
   the analysis unit derives the thickness of the second film of the object based on the relationship information according to the combination of the type and the thickness of the film of the first layer corresponding to the first film of the object as well as the type of the film of the second layer corresponding to the second film, and the measurement parameter related to the object determined by the calculation unit.

7. A film thickness measuring method executed by a film thickness measuring apparatus for measuring a film thickness of an object having a film formed on a substrate, the film thickness measuring method comprising:

   a light irradiation step of irradiating the object with light in a planar manner;
   an imaging step of imaging light from the object;
   a calculation step of deriving a measurement parameter related to the object based on a signal related to the imaging of light in the imaging step;
   a reading step of reading, from a storage unit configured to store relationship information between a film thickness and the measurement parameter, the relationship information; and
   an analysis step of deriving the film thickness of the object based on the relationship information and the measurement parameter related to the object determined in the calculation step, wherein

the relationship information is derived based on theoretical reflectance according to a type of a film and spectral characteristics of the film thickness measuring apparatus.

8. The film thickness measuring method according to claim 7, wherein the storage unit stores the relationship information for each type of the film, and
in the analysis step, the film thickness of the object is derived based on the relationship information according to the type of the film of the object and the measurement parameter related to the object determined in the calculation step.

9. The film thickness measuring method according to claim 7 or 8, wherein the imaging step includes imaging, by a first camera, light that has been reflected by an optical element having transmittance and reflectance changing according to a wavelength in a predetermined wavelength range, the optical element configured to transmit and reflect the light from the object to separate the light, and outputting, by the first camera, a first signal, and includes imaging, by a second camera, light that has passed through the optical element and outputting, by the second camera, a second signal.

10. The film thickness measuring method according to claim 9, wherein in the calculation step, a wavelength centroid is derived as the measurement parameter based on the first signal and the second signal.

11. The film thickness measuring method according to claim 7 or 8, wherein the relationship information is a relationship equation between the film thickness and the measurement parameter derived by plotting and fitting each expected value of the measurement parameter corresponding to each film thickness derived based on the theoretical reflectance and the spectral characteristics.

12. The film thickness measuring method according to claim 8, wherein the object has, as the film, a first film as a first layer stacked on the substrate and a second film as a second layer stacked on the first layer formed,

the storage unit stores the relationship information between a film thickness of the second layer and a measurement parameter for each combination of a type and a thickness of the film of the first layer as well as a type of the film of the second layer, and
in the analysis step, the thickness of the second film of the object is derived based on the relationship information according to the combination of the type and the thickness of the film of the first layer corresponding to the first film of the object as well as the type of the film of the second layer corresponding to the second film, and the measurement parameter related to the object determined in the calculation step.

**Fig.1**

CALCULATION UNIT

ANALYSIS UNIT

STORAGE UNIT

# Fig.2

TRANSMITTANCE

X10

X4

X20

WAVELENGTH

# *Fig.3*

# Fig.4

EP 4 603 791 A1

# Fig.5

**Fig.6**

# Fig.7

$$SC_{T\_xm,yn}(\lambda)$$
$$= A_{xm,ym} + B_{xm,ym}\lambda + C_{xm,ym}\lambda^2 + \cdots$$

$$SC_{R\_xm,yn}(\lambda)$$
$$= A_{xn,yn} + B_{xn,yn}\lambda + C_{xn,yn}\lambda^2 + \cdots$$

EP 4 603 791 A1

**Fig.8**

# Fig.9

EP 4 603 791 A1

THEORETICAL
REFLECTANCE

WAVELENGTH

$$SC_{T\_xm,yn}(\lambda)$$

$$SC_{R\_xm,yn}(\lambda)$$

$$\sum R'(\lambda) \cdot SC_{T\_xm,yn}(\lambda) \implies I_T'$$

$$\sum R'(\lambda) \cdot SC_{R\_xm,yn}(\lambda) \implies I_R'$$

# *Fig.10*

d=110nm

d=100nm

d=90nm

100

100

100

100

$xm,yn$

360

d

x'

$$d_{xm,yn}(x') = a_{xm,yn} + b_{xm,yn}x' + c_{xm,yn}x'^2 + \cdots$$

EP 4 603 791 A1

# Fig.11

FILM
THICKNESS ⇨

MEASURED VALUE x'

$$d_{xm,yn}(x')$$
$$= a_{xm,yn} + b_{xm,yn}x' + c_{xm,yn}x'^2 + \cdots$$

# Fig.12

(a) EXPECTED VALUE OF RATIO $x'' = \dfrac{I_T{}'}{I_R{}'}$

$$d_{xm,yn}(x'')$$
$$= a2_{xm,yn} + b2_{xm,yn}x'' + c2_{xm,yn}x''^2 + \cdots$$

(b) EXPECTED VALUE OF TRANSMISSION INTENSITY $x''' = I_T{}'$

$$d_{xm,yn}(x''')$$
$$= a3_{xm,yn} + b3_{xm,yn}x''' + c3_{xm,yn}x'''^2 + \cdots$$

(c) EXPECTED VALUE OF REFLECTION INTENSITY $x'''' = I_R{}'$

$$d_{xm,yn}(x'''')$$
$$= a4_{xm,yn} + b4_{xm,yn}x'''' + c4_{xm,yn}x''''^2 + \cdots$$

*Fig.13*

# Fig.14

200

200c
200b
200a

*Fig.15*

(a)

(b)

Fig.16

# Fig.17

SECOND LAYER
FILM THICKNESS

CALCULATE SECOND LAYER
FILM THICKNESS BASED ON
MEASURED WAVELENGTH CENTROID
AND FIRST LAYER FILM THICKNESS

AFTER FILM
FORMATION

+

WAVELENGTH CENTROID

FIRST LAYER
FILM THICKNESS

# Fig.18

EP 4 603 791 A1

## INTERNATIONAL SEARCH REPORT

| | International application No. |
|---|---|
| | **PCT/JP2023/038071** |

**A. CLASSIFICATION OF SUBJECT MATTER**

**_G01B 11/06_**(2006.01)i
FI:  G01B11/06 H

According to International Patent Classification (IPC) or to both national classification and IPC

**B. FIELDS SEARCHED**

Minimum documentation searched (classification system followed by classification symbols)

G01B11/06

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2021/161986 A1 (HAMAMATSU PHOTONICS KK) 19 August 2021 (2021-08-19) paragraphs [0017]-[0040], fig. 1-9 | 1-12 |
| Y | JP 2013-032981 A (OTSUKA DENSHI CO LTD) 14 February 2013 (2013-02-14) paragraphs [0113]-[0130], fig. 1, 10-11 | 1-12 |
| A | JP 2004-069651 A (OMRON CORPORATION) 04 March 2004 (2004-03-04) entire text, all drawings | 1-12 |
| A | JP 2005-503547 A (KMAC) 03 February 2005 (2005-02-03) entire text, all drawings | 1-12 |

☐ Further documents are listed in the continuation of Box C.   ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **07 November 2023** | **21 November 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

# EP 4 603 791 A1

## INTERNATIONAL SEARCH REPORT
### Information on patent family members

International application No.

**PCT/JP2023/038071**

| Patent document cited in search report | | | Publication date (day/month/year) | Patent family member(s) | | | Publication date (day/month/year) |
|---|---|---|---|---|---|---|---|
| WO | 2021/161986 | A1 | 19 August 2021 | US | 2023/0058064 | A1 | |
| | | | | paragraphs [0029]-[0052], fig. 1-9 | | | |
| | | | | EP | 4067843 | A1 | |
| | | | | CN | 115104000 | A | |
| | | | | KR | 10-2022-0137615 | A | |
| | | | | TW | 202140993 | A | |
| JP | 2013-032981 | A | 14 February 2013 | US | 2013/0033698 | A1 | |
| | | | | paragraphs [0125]-[0145], fig. 1, 10-11 | | | |
| | | | | CN | 102914268 | A | |
| | | | | KR | 10-2013-0018553 | A | |
| | | | | TW | 201315964 | A | |
| JP | 2004-069651 | A | 04 March 2004 | (Family: none) | | | |
| JP | 2005-503547 | A | 03 February 2005 | US | 2004/0246493 | A1 | |
| | | | | WO | 2003/025497 | A1 | |
| | | | | KR | 10-2003-0025891 | A | |
| | | | | CN | 1556914 | A | |
| | | | | CN | 1808056 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2021161986 A